Europäisches Patentamt

European Patent Office

Office européen des brevets

(11) Veröffentlichungsnummer : **0 007 598**
**B1**

(12) **EUROPÄISCHE PATENTSCHRIFT**

(45) Veröffentlichungstag der Patentschrift :
11.08.82

(21) Anmeldenummer : 79102578.6

(22) Anmeldetag : 20.07.79

(51) Int. Cl.³ : **H 01 C 7/00, H 05 K 1/16,**
**H 01 C 17/12, H 05 K 3/06**

(54) Verfahren zur Herstellung einer elektrischen Schichtschaltung auf Kunststoffolie.

(30) Priorität : 02.08.78 DE 2833919

(43) Veröffentlichungstag der Anmeldung :
06.02.80 (Patentblatt 80/03)

(45) Bekanntmachung des Hinweises auf die Patenterteilung : 11.08.82 Patentblatt 82/32

(84) Benannte Vertragsstaaten :
FR GB IT

(56) Entgegenhaltungen :
FR A 2 084 834
FR A 2 294 610
FR A 2 391 538
US A 3 296 574
US A 3 449 828

(73) Patentinhaber : SIEMENS AKTIENGESELLSCHAFT
Berlin und München
Postfach 22 02 61
D-8000 München 22 (DE)

(72) Erfinder : Juergens, Wilfrid, Dipl.-Phys.
Nibelungen Strasse 55
D-8000 München 19 (DE)
Erfinder : Kausche, Helmold, Dipl.-Phys.
Tessiner Strasse 146
D-8000 München 71 (DE)

Imprimerie Jouve, 18, rue St-Denis, 75001 Paris, France

# Verfahren zur Herstellung einer elektrischen Schichtschaltung auf Kunststoffolie

Die vorliegende Erfindung betrifft ein Verfahren zur Herstellung einer elektrischen Schichtschaltung auf einem Substrat, bei dem Nickelchromwiderstandsschichten auf das Substrat aufgebracht werden, bei dem auf die Nickelchromwiderstandsschichten im Bereich von Kontaktierungsflächen dünne Zwischenschichten aufgestäubt und auf diese dicke Kontaktierungsschichten aufgebracht werden.

Ein derartiges Verfahren ist aus der US-A-3 4 49 828 bekannt. Dort werden auf einem Substrat aus Keramik eine Widerstandsschicht vorzugsweise aus Ni Cr, eine haftvermittelnde Zwischenschicht (z.B. Nickel) und eine Kontaktschicht, z.B. aus Gold, möglichst in gleichem Vakuum aufgesputtert. Eine Temperung ist dort nicht vorgesehen.

Nickelchromschichten müssen in Folienschaltungen getempert werden, damit sie eine hohe Langzeitkonstanz der elektrischen Werte erhalten. Diese Temperung erfolgt üblicherweise bei etwa 200° bis 300 °C. Bei diesen Temperaturen bildet sich auf Nickelchromschichten eine Oxydhaut, welche einen einwandfreien Kontakt mit einer später auf galvanischem Wege oder durch Bedampfung aufgebrachten Verstärkung verhindert. Auch ein Löten, ein Ultraschallschweißen oder ein thermisches Schweißen ergibt nicht die erforderlichen geringen Übergangswiderstände. Daher wurden zur Kontaktierung von Widerstandsschichten auf Nickelchrombasis bisher vor dem Tempern im Bereich von Kontaktierungsflächen Goldschichten aufgebracht. Dieses Verfahren ist relativ teuer und in der Durchführung aufwendig.

Die Aufgabe, die der vorliegenden Erfindung zugrundeliegt, besteht in der Herstellung einer elektrischen Schichtschaltung auf Kunststoffolie, welche eine einwandfreie, wenig aufwendige Kontaktierung von Widerstandsschichten über Kontaktierungsflächen aufweist.

Diese Aufgabe wird bei der eingangs beschriebenen elektrischen Schichtschaltung durch die folgende Reihenfolge von Verfahrensschritten gelöst :

a) Auf eine Kunststoffolie, die als Substrat dient, werden die Nickelchromwiderstandsschichten aufgebracht,

b) die Folie wird getempert,

c) auf die durch die Temperung mit einer Nickelchromoxydschicht überzogenen Nickelchromwiderstandsschichten wird eine dünne Zwischenschicht von etwa 5 nm bis 40 nm Dicke aus einem der Metalle Nickel, Eisen, Kupfer oder Nickelchrom mittels Kathodenzerstäubung aufgestäubt,

d) auf diese Zwischenschicht wird eine für die Kontaktierung ausreichend dicke Kontaktschicht aufgebracht.

Die Zwischenschichten sind mittels Kathodenzerstäubung aufgebracht. So ergibt sich eine feste Verbindung der Schichten mit der Unterlage. Auch die Oxydschichten auf den Nickelchromwiderstandsschichten, die sich im Verlauf der Herstellung bilden, können einen einwandfreien Kontakt nicht verhindern, wenn die vorgeschlagenen Zwischenschichten aufgebracht sind. So ergibt sich eine einwandfreie Kontaktierung und eine erhebliche Einsparung an Material- und Herstellungsaufwand, da Kontaktierungsflächen aus Gold relativ dick ausgeführt sein müssen, um eine Korrosion an den Kontakten zu verhindern und um die notwendige mechanische Festigkeit aufzuweisen. Außerdem kann die Kontaktierungsschicht der Weiterverarbeitung angepaßt werden. Es können gut lötfähige Kontaktierungsflächen ebenso hergestellt werden, wie anderweitig kontaktfähige, beispielsweise mittels Ultaschall- oder mittels thermischem Schweißen.

Durch das erfindungsgemäße Verfahren läßt sich, eine hohe Langzeitkonstanz der elektrischen Werte erreichen. Die Zwischenschicht wird etwa 5 nm bis 40 nm dick aufgestäubt. Sie kann durch entsprechende Blenden auf die Kontaktierungsflächen beschränkt werden. Bei niederohmigen Widerstandsschichten ergibt sich keine unzulässige Veränderung des Widerstandswertes, wenn die Zwischenschicht die niederohmigen Widerstandsschichten vollständig bedeckend aufgestäubt wird. Sollen hochohmige Widerstandsschichten kontaktiert werden, ohne daß auf die relativ komplizierte Abdeckung der Bereiche außerhalb der Kontaktierungsflächen zurückgegriffen werden soll, so empfiehlt es sich, daß eine Zwischenschicht aus Kupfer die hochohmigen Widerstandsschichten vollständig überdeckend aufgestäubt wird und daß anschließend die Zwischenschicht außerhalb der Kontaktierungsflächen weggeätzt wird, ohne daß die Widerstandsschicht angegriffen wird. Hierzu sind Metallchloridlösungen geeignet, z.B. Zinkchloridlösung.

Die Erfindung wird nun anhand einer Figur näher erläutert. Sie stellt eine nach dem erfindungs gemäßen Verfahren hergestellte elektrische Schichtschaltung in teilweise geschnittener und gebrochener Ansicht dar.

Auf eine Substratfolie aus Kunststoff 1 ist eine Nickelchromwiderstandsschicht 2 aufgebracht. Diese ist getempert, um eine hohe Langzeitkonstanz der Widerstandswertes zu erreichen. Dabei hat sich eine Nickelchromoxydschicht 3 gebildet. Die aufgestäubte Zwischenschicht 4 stellt durch diese Nickelchromoxydschicht 3 hindurch einen einwandfreien elektrischen Kontakt mit der Nickelchromwiderstandsschicht 2 her. Auf diese aufgestäubte Zwischenschicht 4 sind im Bereich von Kontaktierungsflächen Kontaktierungsschichten 5 aufgebracht. Die Zwischenschicht 4 kann die Nickelchromwiderstandsschicht 2 vollständig bedecken, wenn die Nickelchromwiderstandsschicht 2 niederohmig ist, so daß sich keine unzulässige Veränderung des Widerstands-

wertes ergibt.

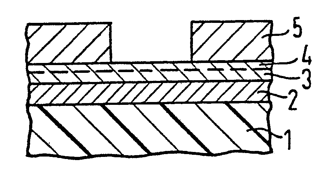

## Ansprüche

1. Verfahren zur Herstellung einer elektrischen Schichtschaltung auf einem Substrat (1), bei dem Nickelchromwiderstandsschichten (2) auf das Substrat aufgebracht werden, bei dem auf die Nickelchromwiderstandsschichten im Bereich von Kontaktierungsflächen dünne Zwischenschichten (4) aufgestäubt und auf diese dicke Kontaktierungsschichten (5) aufgebracht werden, gekennzeichnet durch die folgende Reihenfolge von Verfahrensschritten :

a) Auf eine Kunststoff-Folie (1), die als Substrat dient, werden die Nickelchromwiderstandsschichten (2) aufgebracht,

b) die Folie wird getempert,

c) auf die durch die Temperung mit einer Nickelchromoxydschicht (3) überzogenen Nickelchromwiderstandsschichten (2) wird eine dünne Zwischenschicht (4) von etwa 5 nm bis 40 nm Dicke aus einem der Metalle Nickel, Eisen, Kupfer oder Nickelchrom mittels Kathodenzerstäubung aufgestäubt,

d) auf diese Zwischenschicht (4) wird eine für die Kontaktierung ausreichend dicke Kontaktschicht (5) aufgebracht.

2. Verfahren nach Anspruch 1, dadurch gekennzeichnet, daß die Zwischenschicht (4) auf eine niederohmige Widerstandsschicht (2, 3) diese vollständig bedeckend aufgestäubt wird.

3. Verfahren nach Anspruch 1, dadurch gekennzeichnet, daß eine Zwischenschicht (4) aus Kupfer auf eine hochohmige Widerstandsschicht (2, 3) diese vollständig bedeckend aufgestäubt wird und daß anschließend die Zwischenschicht (4) außerhalb der Kontaktierungsflächen weggeätzt wird, ohne daß die Widerstandsschicht angegriffen wird.

## Claims

1. A process for the production of an electrical film circuit on a substrate (1), in which nickel-chromium resistance layers (2) are applied to the substrate, thin intermediate layers (4) are deposited in finely-divided form onto the nickel-chromium resistance layers in the region of contact surfaces, and thick contact surfaces (5) are applied to these intermediate layers, characterised by the following sequence of process steps :

a) nickel-chromium resistance layers (2) are applied to a plastics film (1) which serves as a substrate ;

b) the film is annealed ;

c) a thin intermediate layer (4) which has a thickness of about 5 nm to 40 nm and consists of one of the metals nickel, iron, or copper, or of nickel-chromium is deposited by cathode sputtering onto the nickel-chromium resistance layers (2), which are covered with a nickel-chromium oxide layer (3) as a result of the annealing step ; and

d) a contact layer (5) which has a thickness sufficient for contacting is applied to the intermediate layer (4).

2. A process as claimed in Claim 1, characterised in that the intermediate layer (4) is deposited onto a low-resistance resistance layer (2, 3) so as to cover the latter completely.

3. A process as claimed in Claim 1, characterised in that an intermediate layer (4) consisting of copper is deposited onto a high-resistance resistance layer (2, 3) so as to completely cover the latter and that the intermediate layer (4) is subsequently etched away outside the contact surfaces without the resistance layer being attacked.

## Revendications

1. Procédé pour fabriquer un circuit électrique à couches sur un substrat (1), dans lequel des couches résistantes au nickel-chrome (2) sont déposées sur le substrat, dans lequel on pulvérise sur les couches résistantes un nickel-chrome, dans la partie des surfaces de contact, de minces couches intermédiaires (4) sur lesquelles on dépose des couches de contact épaisses (5), caractérisé par la suite des phases opératoires suivantes :

a) sur une feuille de matière plastique (1) qui sert de substrat, on dépose les couches résistantes au nickel-chrome (2),

b) la feuille est soumise à un traitement thermique,

c) sur les couches résistantes au nickel-chrome (2), revêtues d'une couche au nickel-oxyde de chrome (3) par suite du traitement thermique, est déposée par pulvérisation cathodique une mince couche auxiliaire (4) d'une épaisseur d'environ 5 nm à 40 nm de l'un des métaux nickel, fer, cuivre ou nickel-chrome,

d) sur cette couche intermédiaire (4) est déposée une couche de contact (5) d'une épaisseur suffisante pour la réalisation du contact ou bonding.

2. Procédé selon la revendication 1, caractérisé par le fait que la couche intermédiaire (4) est déposée par pulvérisation sur une couche résistante (2, 3) faiblement ohmique et la recouvrant complètement.

3. Procédé selon la revendication 1, caractérisé par le fait qu'une couche intermédiaire (4) en cuivre est déposée par pulvérisation sur une couche résistante fortement ohmique (2, 3) qu'elle recouvre entièrement et qu'ensuite la couche intermédiaire (4) est enlevée par attaque chimique, en dehors des surfaces de contact, sans que la couche résistante soit attaquée.